# EUROPÄISCHE PATENTANMELDUNG

(11) **EP 1 630 880 A2**
(43) Veröffentlichungstag der Anmeldung: **01.03.2006**
(21) Anmeldenummer: 05107162.9
(22) Anmeldetag: 03.08.2005
(51) Int. Cl.: H01L 45/00

(54) **Speicherbauelement (CBRAM) mit Speicherzellen auf der Basis eines in seinem Widerstandswert änderbaren aktiven Festkörper-Elektrolytmaterials und Herstellungsverfahren dafür**

(30) Priorität: 30.08.2004 DE 102004041894
(71) Anmelder: Infineon Technologies AG, 81669 München (DE)
(72) Erfinder: Symanczyk, Ralf, 81673, München (DE); Röhr, Thomas, 85609, Aschheim (DE)
(74) Vertreter: Kottmann, Heinz Dieter

(57) **Zusammenfassung**

Die Erfindung betrifft ein Speicherbauelement (CBRAM) mit Speicherzellen (1) auf der Basis eines in seinem Widerstandswert änderbaren aktiven Festkörper-Elektroytmaterials (13), das, eingebettet zwischen einer unteren und oberen Elektrode (BE, TE) durch Anlegen eines geeigneten elektrischen Feldes zwischen diesen Elektroden zwischen einem Ein-Zustand mit einem geringen Widerstand und einem Aus-Zustand mit einem dem gegenüber hohen Widerstand schaltbar ist, das dadurch gekennzeichnet ist, dass parallel zum Festkörper-Elektrolytmaterial (13) zwischen den Elektroden (BE, TE) ein Widerstandsmaterial (10) eingebettet ist, und ein vorteilhaftes Herstellungsverfahren dafür.

## Beschreibung

Speicherbauelement (CBRAM) mit Speicherzellen auf der Basis eines in seinem Widerstandswert änderbaren aktiven Festkörper-Elektrolytmaterials und Herstellungsverfahren dafür

Die Erfindung betrifft ein Speicherbauelement (CBRAM) mit Speicherzellen auf der Basis eines in seinem Widerstandswert änderbaren aktiven Festkörper-Elektroytmaterials, das, eingebettet zwischen einer unteren und oberen Elektrode, durch Anlegen eines geeigneten elektrischen Feldes zwischen diesen Elektroden zwischen einem Ein-Zustand mit einem geringen Widerstand und einem Aus-Zustand mit einem dem gegenüber hohen Widerstand schaltbar ist, sowie ein Herstellungsverfahren dafür.

Verschiedene Halbleiterspeichertechnologien, die auf dem Prinzip des Schaltens des elektrischen Widerstandes beruhen, werden zur Zeit intensiv erforscht. Ein Erfolg versprechendes Konzept, das auf einem Festkörper-Elektrolytmaterial beruht, ist in der Literatur auch als PMC (Programmable Metallization Cell) oder CBRAM (Conductive Bridging Random Access Memory) bekannt (vgl.: M. N. Kozicki, M. Yun, L. Hilt, A. Singh, Applications of programmable resistance changes in metaldoped chalcogenides, Electrochemical Society Proc., Vol. 99-13 (1999) 298; R. Neale, Micron to look again at non-volatile amorphous memory, Electron Engineering Design (2002); B. Prince, Emerging Memories - Technologies and Trends, Kluwer Academic Publishers (2002); R. Symanczyk et al. Electrical Characterization of Solid State Ionic Memory Elements, Proceedings Non-Volatile Memory Technology Symposium (2003) 17-1) .

Das Funktionsprinzip nutzt die Ausbildung und das Löschen eines niederohmigen Kanals in einem hochohmigen Festkörper-Elektrolytmaterial beim Anlegen geeigneter elektrischer Felder. Dadurch ist ein resistives Schalten zwischen dem hochohmigen und einem niederohmigen Zustand möglich. Den beiden Widerstandswerten kann jeweils ein logischer Zustand zugeordnet werden.

Bei den oben erwähnten CBRAM-Speicherzellen werden, bedingt durch den sehr hochohmigen Zustand des Festkörper-Elektrolytmaterials im nicht programmierten Zustand, sehr hohe Verhältnisse des Aus-Widerstands zum Ein-Widerstand erreicht. Typische Werte sind R(aus)/R(ein) > 10⁶ bei R(aus) > 10¹⁰ Ω und einer aktiven Zellfläche < 1 µm². Gleichzeitig ist diese Technologie gekennzeichnet durch geringe Schaltspannungen kleiner als 100 mV für das Initiieren des Löschvorgangs und kleiner als 300 mV für den Schreibvorgang.

Bei der Realisierung eines Zellenarrays mit Auswerte- und Ansteuer-Logik sind mit den hohen Widerstandswerten allerdings mehrere Nachteile verbunden:
- Empfindlichkeit gegen Störspannungen;
- großer Rückkopplungswiderstand in einem typischen Leseverstärker und damit ein hoher Flächenbedarf bei Ausführung in CMOS-Technologie; und
- hohe RC-Zeitkonstanten.

Besonders kritisch ist die Störempfindlichkeit einer Zelle mit extrem hohem R(aus). Da auch der Widerstand eines ausgeschalteten Feldeffekttransistors im Bereich von 10¹⁰ Ω liegt, ist ein Schaltungsknoten zwischen einem solchen Transistor und einer hochohmigen CBRAM-Speicherzelle praktisch völlig isoliert und damit sehr empfindlich gegenüber kapazitiven Einkopplungen. Außerdem führen schon extrem geringe Leckströme zum Aufbau von Störspannungen. Beide Effekte können ein unerwünschtes Programmieren der CBRAM-Zelle zur Folge haben.

Darüber hinaus weisen die Zellen eine Degradation des Aus-Zustandes über die Lebensdauer insbesondere bei Stressbedingungen wie Endurance-Tests auf. Diese Degradation zeigt sich in einer Verringerung des Aus-Widerstandes und bedeutet eine unerwünschte Inhomogenität der Zellkennwerte in einem Speicherarray und über die Betriebsdauer des Bauelements.

Es existieren weitere Speicherkonzepte auf der Basis von in ihrem Widerstandswert schaltbaren Speicherzellen, wie z.B. MRAM- oder PCRAM-Speicher. Bei diesen Konzepten sind das Aus/Ein-Widerstandsverhältnis sowie der Ausschaltwiderstand deutlich geringer im Vergleich zum CBRAM. Die hier beschriebene Problematik tritt in dieser Form bei diesen anderen Speicherkonzepten nicht auf. Beim MRAM werden Aus/Ein-Widerstandsverhältnisse von bis zu 70 % erreicht und beim PCRAM liegen die Werte typischerweise im Bereich kleiner als 10³ mit einem R(aus) kleiner als 1 MΩ.

Es ist deshalb Aufgabe der Erfindung, ein Speicherbauelement der eingangs genannten Art zu ermöglichen, bei dem die Störempfindlichkeit der Zellen und auch die Empfindlichkeit gegenüber kapazitiven Einkopplungen verringert und der zuvor geschilderte Alterungseffekt der Zellen unterdrückt sind, so dass der Effekt nach außen nicht mehr messbar ist. Eine weitere Aufgabe besteht darin, ein Verfahren zur Herstellung eines solchen CBRAM-Speicherbauelements anzugeben. Diese Aufgaben werden anspruchsgemäß gelöst.

Beim erfindungsgemäßen Speicherbauelement wird der Aus-Widerstand der Zellen durch das Layout und das Herstellungsverfahren definiert. Dies wird durch einen Parallelwiderstand zur aktiven Schicht erreicht. Der Aus-Widerstand und das Aus/Ein-Widerstandsverhältnis sind damit nicht mehr durch die Materialeigenschaften der Schicht des aktiven Festkörper-Elektrolytmaterials allein bestimmt, sondern lassen sich den Bedürfnissen der Auswertelogik und der gewünschten Applikation anpassen. Die zuvor geschilderten Nachteile, die durch den hohen Aus-Widerstand der Zelle bedingt sind, entfallen. Weiterhin kann der Aus-Widerstand der Zellen so eingestellt werden, dass der Alterungseffekt des Festkörper-Elektrolytmaterials nach außen nicht mehr messbar ist. Wird der Aus-Widerstand einer Zelle beispielsweise bei der Herstellung auf einen Wert von 10⁷ Ω eingestellt, so sind Degradationen des Widerstandes des aktiven Festkörper-Elektrolytmaterials von 10¹⁰ Ω auf 10⁸ Ω für die Schaltung und den Betrieb vernachlässigbar und als konstant anzusehen.

Der Kern der Erfindung ist die Implementierung eines Widerstandes parallel zu den aktiven Schichten für jede Zelle eines Speicherarrays. Dieser zusätzliche Parallelwiderstand wird durch geeignete Prozessführung und Materialauswahl auf einen Widerstandswert eingestellt, der zwischen dem Ein- und dem Aus-Widerstand des aktiven Festkörper-Elektrolytmaterials liegt. Nach außen wird daher der Ein-Widerstand der Zelle durch die Kanalbildung im aktiven Material und der Aus-Widerstand durch das Layout bzw. den Parallelwiderstand definiert.

Die Erfindung gibt weiterhin ein den obigen zweiten Aufgabeteil lösendes Herstellungsverfahren an, das zur Realisierung des erfindungsgemäßen Konzepts geeignet ist. Dieses Herstellungsverfahren basiert auf einem selbst strukturierenden Maskenprozess mittels anodischer Oxidation von Aluminium. Diese Oxidation führt zur Bildung eines hexagonalen dichten Gitters im Nanometerbereich. Je nach Ausführungsbeispiel wird entweder für die Stützstruktur oder für die Ausfüllung der gebildeten Nanoporen ein Widerstandsmaterial mit geeignetem spezifischen Widerstand gewählt, so dass sich der gewünschte Parallelwiderstand ergibt.

Die obigen und weitere vorteilhafte Merkmale der Erfindung werden in der nachfolgenden Beschreibung bezogen auf die beiliegende Zeichnung näher beschrieben. Die Zeichnungsfiguren zeigen im Einzelnen:
- Fig. 1A - 1G: schematische Schnittdarstellungen zur Erläuterung einzelner Prozessschritte eines ersten Ausführungsbeispiels eines erfindungsgemäßen Herstellungsverfahrens für ein CBRAM-Speicherbauelement, bei dem eine nanoporöse Aluminiumoxidschicht als Positivmaske verwendet wird;
- Fig. 2A - 2G: schematische Querschnittsansichten zur Erläuterung einzelner Prozessschritte eines zweiten Ausführungsbeispiels eines erfindungsgemäßen Herstellungsverfahrens für ein CBRAMSpeicherbauelement, bei dem eine nanoporöse Aluminiumoxidschicht als Negativmaske verwendet wird;
- Fig. 3A - 3G: schematische Querschnittsdarstellungen zur Erläuterung einzelner Prozessschritte eines dritten Ausführungsbeispiels eines erfindungsgemäßen Herstellungsverfahrens, bei dem eine Negativmaske in Form einer nanoporösen Aluminiumoxidschicht in Verbindung mit einem CMP-Schritt verwendet wird, und
- Fig. 4: ein Querschnitt durch ein erfindungsgemäßes CBRAM-Speicherbauelement, wie es mit einem der Herstellungsverfahren gemäß dem ersten bis dritten Ausführungsbeispiel herstellbar ist.

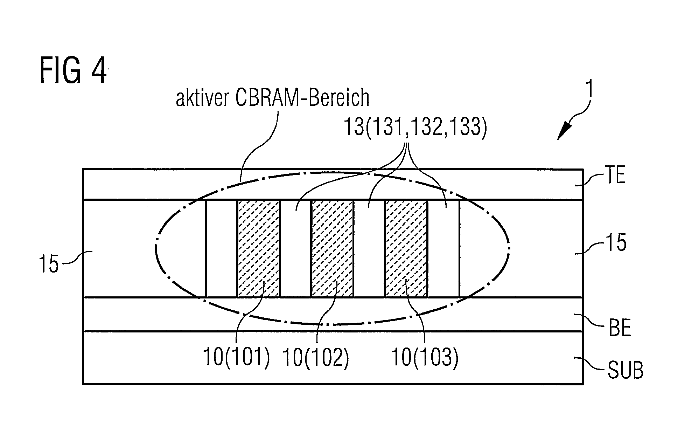

Bezogen auf Fig. 4 weist ein erfindungsgemäßes CBRAM-Speicherbauelement Speicherzellen 1 auf der Basis eines in seinem Widerstandswert änderbaren aktiven Festkörper-Elektrolytmaterials 13 bzw. 131, 132, 133 auf, das, eingebettet zwischen einer unteren Elektrode BE (Bottom Electrode) und einer oberen Elektrode TE (Top Electrode) durch Anlegen eines geeigneten elektrischen Feldes zwischen diesen Elektroden BE, TE zwischen einem Ein-Zustand mit einem geringen Widerstand und einem Aus-Zustand mit einem im Vergleich dazu hohen Widerstand schaltbar ist und ist dadurch gekennzeichnet, dass parallel zum Festkörper-Elektrolytmaterial 13, 131, 132, 133 im aktiven CBRAM-Bereich zwischen den Elektroden BE, TE ein Widerstandsmaterial 10 bzw. 101, 102, 103 eingebettet ist. Lateral ist die Speicherzelle 1 durch die Einbettung des Schichtstapels in eine dielektrische Schicht 15 zur Isolierung benachbarter Zellen strukturiert.

Durch die erfindungsgemäß vorgeschlagenen Maßnahmen ist der Widerstandswert des Widerstandsmaterials einstellbar und zwar vorzugsweise auf einen Wert, der zwischen dem Widerstandswert des aktiven Festkörper-Elektrolytmaterials im Ein-Zustand und im Aus-Zustand liegt. Während es ohne weiteres verständlich ist, dass sich der Widerstandswert des Widerstandsmaterials durch die Wahl seines spezifischen Widerstands einstellen lässt, wird bei der Erfindung der Widerstandswert des Widerstandsmaterials zusätzlich durch ein geeignetes Layout seiner Schicht und/oder durch ein geeignetes Layout des Festkörper-Elektrolytmaterials zwischen den Elektroden eingestellt.

Die nachstehend beschriebenen drei bevorzugten Ausführungsbeispiele des erfindungsgemäßen Herstellungsverfahrens verwenden zur Strukturierung des Widerstandsmaterials und der Schicht des Festkörperelektrolytmaterials zwischen den Elektroden eine als Positivmaske oder als Negativmaske fungierende Nanoporen aufweisende Aluminiumoxidschicht. Die anodische Oxidation einer Aluminiumschicht in geeigneten Elektrolyten (z.B. Oxalsäure, Schwefelsäure) führt je nach Wahl der Schichtdicke und der Ätzbedingungen, wie Ätzzeit, elektrische Spannung, chemische Konzentration zu homogenen, hexagonal dichten Anordnungen von Poren mit Durchmessern bis hinunter zu 4 nm (vgl.: H. Masuda and K. Fukuda, Ordered Metal Nanohole Arrays Made by a Two-Step Replication of Honeycomb Structures of Anodic Alumina, Science 268, 1995; K. Liu et al., Fabrication and thermal stability of arrays of Fe nanodots, Appl. Phys. Lett. 81, 2002). Diese Anordnung dient als Maske für die Abscheidung des aktiven Materials und des Materials für den Parallelwiderstand, und zwar kann je nach Prozessführung zwischen einem Verfahren mit Positivmaske und einem Verfahren mit Negativmaske unterschieden werden.

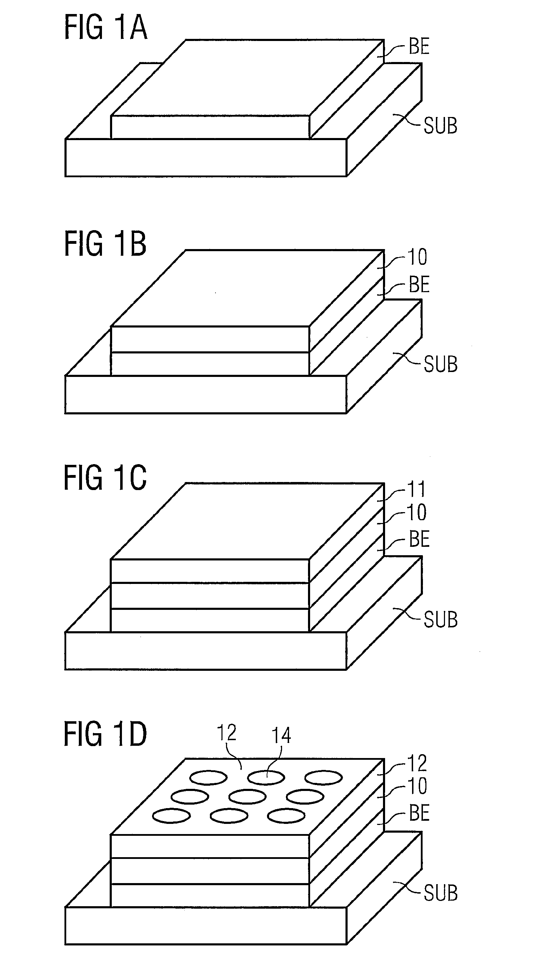

Ein erstes bevorzugtes Ausführungsbeispiel eines erfindungsgemäßen Herstellungsverfahrens wird nachstehend anhand der Fig. 1A - 1G beschrieben. Bei diesem Herstellungsverfahren wird die oben erwähnte Aluminiumoxidschicht mit den Nanoporen als eine Positivmaske für die Strukturierung des Widerstandsmaterials für den Parallelwiderstand sowie zur Strukturierung des Festkörper-Elektrolytmaterials für die aktive Schicht verwendet.

Zunächst wird gemäß Fig. 1A die Metallisierung für die untere Elektrode BE auf einem Substrat SUB abgeschieden und strukturiert. Als Elektrodenmetall kann z.B. Wolfram, TiN, TiW, TiA1N oder andere verwendet werden. Gemäß Fig. 1B wird auf der unteren Elektrode BE eine Schicht 10 aus einem leitfähigen Widerstandsmaterial für den Parallelwiderstand abgeschieden. Darüber wird gemäß Fig. 1C eine Aluminiumschicht 11 abgeschieden und gemäß Fig. 1D anodisch oxidiert und dabei zu einer nanoporösen Al₂O₃―Schicht 12 mit Nanoporen 14 umgewandelt. Die entstandenen Nanoporen 14 haben einen mittleren Durchmesser bis hinunter zu 4 nm und einen typischen Durchmesser von annähernd 10 nm.

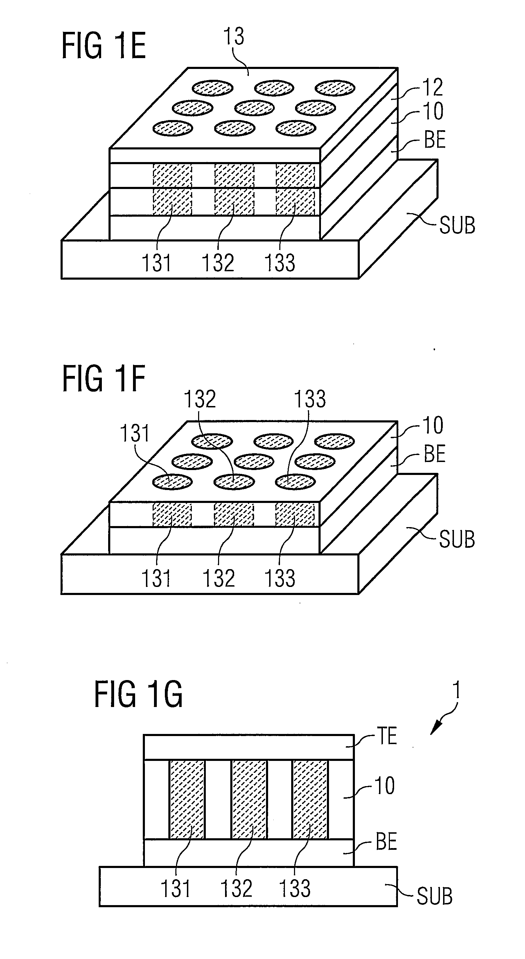

Gemäß Fig. 1E wird zunächst das Widerstandsmaterial der Schicht 10 durch die Nanoporen 14 der Al₂O₃―Schicht 12 hindurch geätzt, so dass auch in der Schicht 10 des Widerstandsmaterials Nanoporen entstehen. Anschließend wird ebenfalls gemäß Fig. 1E eine Schicht 13 eines aktiven Festkörper-Elektrolytmaterials über der Al₂O₃-Schicht 12, durch deren Nanoporen 14 und die in der Widerstandsschicht 10 gebildeten Nanoporen hinein abgeschieden, so dass sich darin Nanosäulen 131, 132 und 133 aus dem aktiven Festkörper-Elektrolytmaterial bilden. Das aktive Festkörper-Elektrolytmaterial der Schicht 13 und der Nanosäulen 131 - 133 kann z.B. GeSe und Ag oder GeS und Ag sein.

Gemäß Fig. 1F wird anschließend die über der Widerstandsschicht 10 mit den Nanosäulen 131 - 133 des aktiven Festkörper-Elektrolytmaterials liegende Aluminiumoxidschicht 12 z.B. durch Lift-Off oder selektives Ätzen entfernt, wobei sich der in Fig. 1F gezeigte Prozesszustand einstellt. Statt des Lift-Offs oder selektiven Ätzens der Al₂O₃―Schicht können alternativ die über der Schicht 10 des Widerstandsmaterials stehenden Schichten 12 und 13 durch CMP rückgedünnt werden. Abschließend erfolgt gemäß Fig. 1G die Abscheidung der Metallisierung für die obere Elektrode TE. Es sei hier erwähnt, dass die in Fig. 1G nicht gezeigte laterale Strukturierung durch die Einbettung des Schichtstapels in eine dielektrische Schicht 15 zur Isolierung benachbarter Zellen erfolgt (vgl.
Fig. 4). Mit diesem Isolations- und lateralen Strukturierungsschritt ist die CBRAM-Speicherzelle 1 komplett.

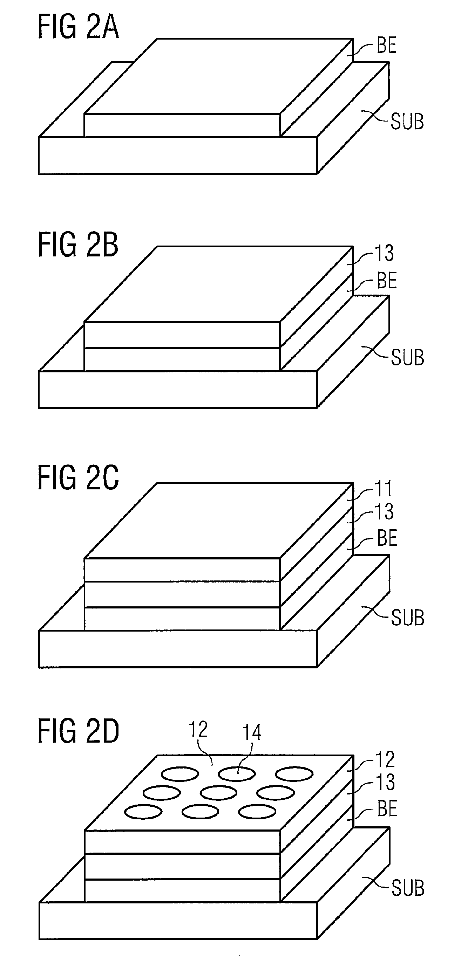

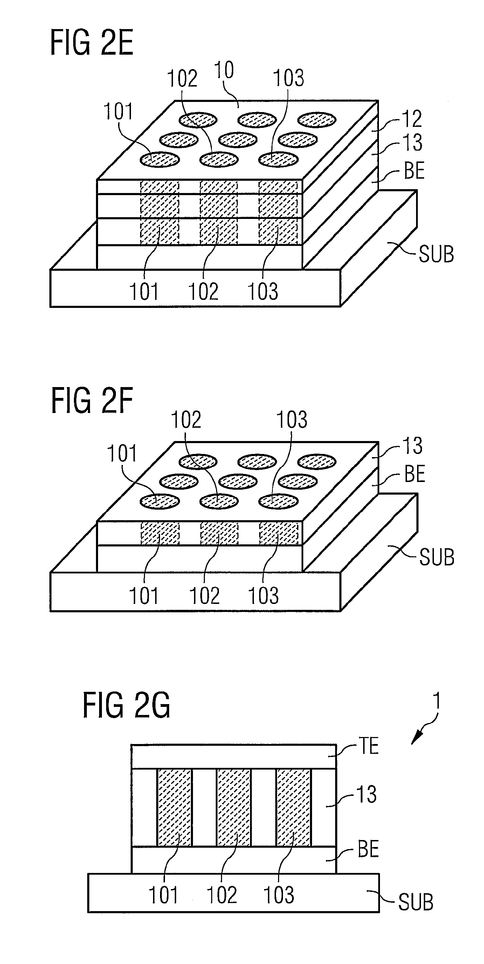

Ein zweites bevorzugtes Ausführungsbeispiel eines erfindungsgemäßen Herstellungsverfahrens einer CBRAM-Speicherzelle, bei dem die nanoporöse Aluminiumoxidschicht als Negativmaske dient, wird nachstehend anhand der Fig. 2A - 2G beschrieben. Wie beim zuvor beschriebenen ersten Ausführungsbeispiel wird bei diesem bevorzugten Ausführungsbeispiel von der auf einem Substrat SUB abgeschiedenen und strukturierten unteren Elektrode BE, z.B. aus W, TiN, TiW, TiAlN oder anderen ausgegangen (Fig. 2A). Anschließend wird über der unteren Elektrode BE die Schicht 13 des aktiven Festkörper-Elektrolytmaterials z.B. GeSe, GeS und Ag abgeschieden (Fig. 2B). Über der Schicht 13 des aktiven Festkörper-Elektrolytmaterials wird anschließend gemäß Fig. 2C eine Aluminiumschicht 11 abgeschieden und gemäß Fig. 2D anodisch oxidiert, wodurch eine Al₂O₃-Schicht 12 mit Nanoporen 14 erzeugt wird. Anschließend wird zunächst gemäß Fig. 2E die Schicht 13 des aktiven Festkörper-Elektrolytmaterials durch die in der Aluminiumoxidsschicht 12 gebildeten Nanoporen 14 hindurch selektiv geätzt, so dass in der Schicht 13 des aktiven Materials ebenfalls Nanoporen erzeugt werden. Danach wird ebenfalls gemäß Fig. 2E eine Schicht 10 eines Widerstandsmaterials für den Parallelewiderstand abgeschieden und zwar über der Aluminiumoxidschicht 12, durch deren Nanoporen 14 hindurch und bis in die in der aktiven Schicht 13 gebildeten Nanoporen hinein. Dies ist durch die mit 101, 102 und 103 bezeichneten Säulen aus Widerstandsmaterial angegeben. Der spezifische Widerstand und die Geometrie des Widerstandsmaterials, das heißt im Wesentlichen die Anzahl und der Durchmesser der Nanoporen innerhalb der aktiven Schicht 13 bestimmen R(aus). Das Widerstandsmaterial kann z.B. dotiertes Polysilizium oder TiN sein. Anschließend wird gemäß Fig. 2F die restliche Aluminiumoxidschicht 12 z.B. durch Lift-Off oder selektives Ätzen entfernt. Dabei wird das Material der Widerstandsschicht 10 oberhalb der Aluminiumoxidschicht 12 und in deren Nanoporen ebenfalls entfernt. Alternativ kann auch hier durch CMP eine Rückdünnung bis zur aktiven Schicht 13 ausgeführt werden. Abschließend wird gemäß Fig. 2G die obere Elektrode TE über der aktiven Schicht 13 und den darin gebildeten Nanosäulen 101 - 103 des Widerstandsmaterials abgeschieden und strukturiert. Die nach dem zweiten bevorzugten Ausführungsbeispiel gemäß Fig. 2G hergestellte CBRAM-Speicherzelle 1 wird schließlich durch die in Fig. 4 gezeigte Einbettung des Schichtstapels in eine dielektrische Schicht 15 lateral strukturiert und damit zu benachbarten Zellen hin isoliert.

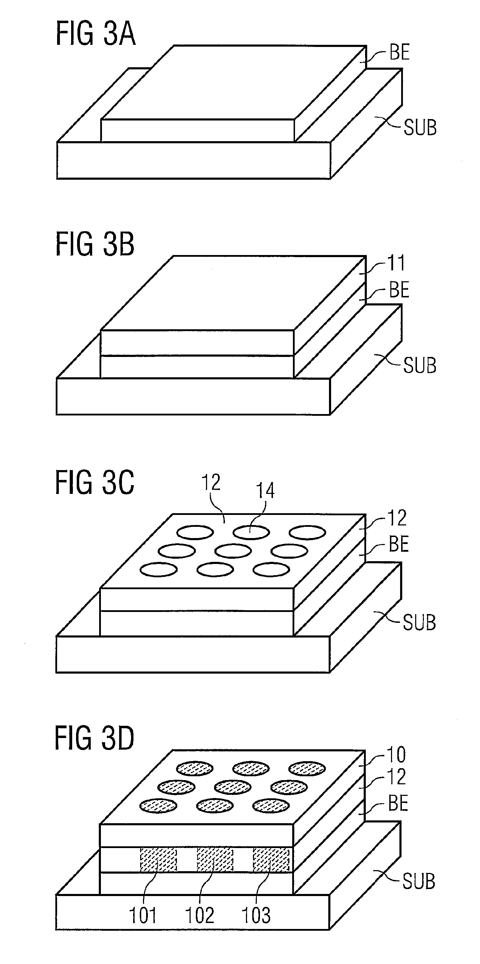

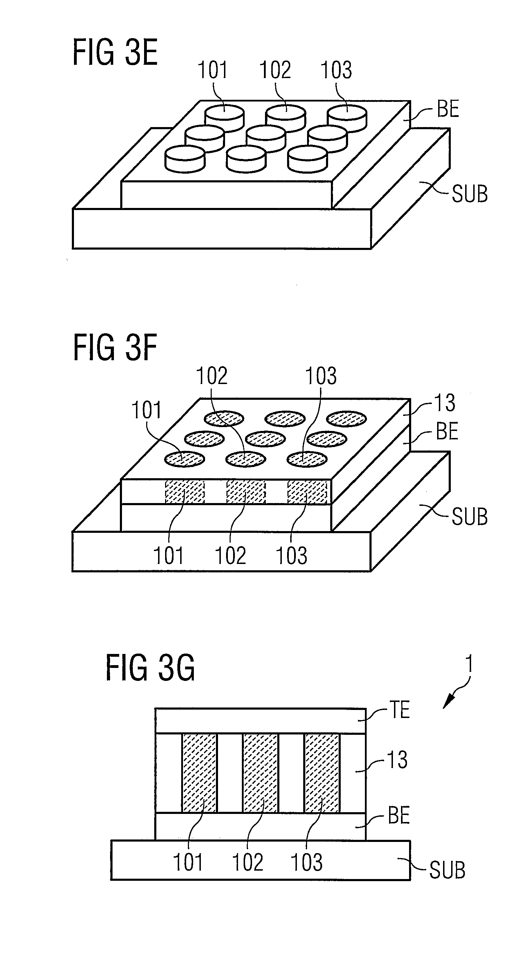

Das anhand der Fig. 3A - 3G beschriebene dritte bevorzugte Ausführungsbeispiel ist eine Alternative zu dem anhand der Fig. 2A - 2G beschriebenen Prozess und nutzt einen CMP-Schritt zur Strukturierung des aktiven Materials. Ausgangspunkt ist wieder gemäß Fig. 3A die auf einem Substrat SUB abgeschiedene und strukturierte Metallisierung für die untere Elektrode BE. Die Aluminiumschicht 11 wird dann gemäß Fig. 3B direkt auf der unteren Elektrode BE abgeschieden und gemäß Fig. 3C anodisch zu einer Al₂O₃-Schicht 12 mit den Nanoporen 14 oxidiert. Der gewünschte Durchmesser der Nanoporen 14 ist auch hier etwa 10 nm. Anschließend wird gemäß Fig. 3D die Schicht 10 aus Widerstandsmaterial über der Aluminiumoxidschicht 12 und in deren Nanoporen hinein abgeschieden. Durch Lift-Off oder selektives Ätzen wird dann gemäß Fig. 3E die restliche Aluminiumoxidschicht 12 entfernt. Dabei bleiben Nanosäulen 101, 102, 103 des zuvor abgeschiedenen Widerstandsmaterials 10 auf der unteren Elektrode BE stehen. Darüber wird gemäß Fig. 3F die Schicht 13 des aktiven Festkörper-Elektrolytmaterials abgeschieden und durch CMP bis zu den Nanosäulen 101 - 103 des Widerstandsmaterials rückgedünnt. Über der aktiven Schicht 13 wird dann gemäß Fig. 3G die Metallisierung für die obere Elektrode TE abgeschieden. Auch bei diesem dritten bevorzugten Ausführungsbeispiel wird der Aus-Widerstand R(aus) durch den spezifischen Widerstand und des Widerstandsmaterials 10 und die Geometrie der mit dem Widerstandsmaterial 10 gefüllten Nanosäulen 101 - 103 bestimmt. Schließlich erfolgt auch hier die laterale Strukturierung durch die Einbettung des Schichtstapels der CBRAM-Speicherzelle in eine dielektrische Schicht 15 zur Isolierung benachbarter Zellen (Fig. 4).

Zuvor wurden anhand der Fig. 1A - 1G, 2A - 2G, 3A - 3G und Fig. 4 drei bevorzugte Ausführungsbeispiele eines Verfahrens zur Herstellung von Speicherbauelementen mit Speicherzellen auf der Basis eines in seinem Widerstandswert änderbaren aktiven Festkörper-Elektrolytmaterial beschrieben, das zwischen einer unteren Elektrode und einer oberen Elektrode eingebettet ist und das sich dadurch auszeichnet, dass ein Widerstandsmaterial parallel zum Festkörper-Elektrolytmaterial zwischen die untere und obere Elektrode eingebettet wird. Diese Prozesse nutzen eine in geeigneten Elektrolyten, z.B. Oxalsäure, Schwefelsäure, anodisch oxidierte Aluminiumschicht, bei der sich je nach Wahl der Schichtdicke und Ätzbedingungen, wie Ätzzeit, elektrische Spannung, chemische Konzentration des Elektrolyts, homogene, hexagonal dichte Anordnungen von Nanoporen mit Durchmessern bis hinunter zu 4 nm ausbilden. Diese Aluminiumoxidschicht mit den Nanoporen dient als Maske für die Abscheidung des aktiven Materials und des Materials für den Parallelwiderstand. Bei dem ersten bevorzugten Ausführungsbeispiel gemäß den Fig. 1A - 1G diente die nanoporöse Aluminiumoxidschicht als Positivmaske, während sie bei dem zweiten und dritten Ausführungsbeispiel jeweils gemäß den Fig. 2A - 2G und 3A - 3G als Negativmaske verwendet wird. Mit diesen drei bevorzugten Ausführungsbeispielen des erfindungsgemäßen Herstellungsverfahrens wird der Aus-Widerstand R(aus) der CBRAM-Zellen 1 durch das Layout und das Herstellungsverfahren definiert. Der Aus-Widerstand und das Verhältnis R(aus)/R(ein) sind damit nicht mehr durch die Materialeigenschaften allein bestimmt sondern lassen sich den Bedürfnissen der Auswertelogik und der gewünschten Applikation anpassen. Damit lassen sich die aufgrund des hohen Werts des Aus-Widerstands des Elektrolytmaterials in der CBRAM-Zelle entstehenden Nachteile vermeiden. Weiterhin kann der Alterungseffekt des Elektrolytmaterials in der CBRAM-Zellen so unterdrückt werden, dass er nach außen nicht mehr messbar ist.

### Bezugszeichenliste

- 1: CBRAM-Speicherzelle
- 10: Widerstandsmaterial und Schicht des Widerstandsmaterials
- 11: Aluminiumschicht
- 12: Aluminiumoxidschicht
- 13: aktives Festkörperelektrolytmaterial und Schicht desselben
- 14: Nanoporen
- 131, 132, 133: Nanosäulen des aktiven FestkörperElektrolytmaterials 13
- 101, 102, 103: Nanosäulen des Widerstandsmaterials 10
- 15: isolierendes Dielektrikum
- BE: untere Elektrode
- SUB: Substrat
- TE: obere Elektrode

## Patentansprüche

1. Speicherbauelement (CBRAM) mit Speicherzellen (1) auf der Basis eines in seinem Widerstandswert änderbaren aktiven Festkörper-Elektroytmaterials (13), das, eingebettet zwischen einer unteren und oberen Elektrode (BE, TE) durch Anlegen eines geeigneten elektrischen Feldes zwischen diesen Elektroden zwischen einem Ein-Zustand mit einem geringen Widerstand und einem Aus-Zustand mit einem dem gegenüber hohen Widerstand schaltbar ist,
**dadurch gekennzeichnet ,**
**dass** parallel zum Festkörper-Elektrolytmaterial (13) zwischen den Elektroden (BE, TE) ein Widerstandsmaterial (10) eingebettet ist.

2. Speicherbauelement nach Anspruch 1,
**dadurch gekennzeichnet ,**
**dass** der Widerstandswert des Widerstandsmaterials (10) einstellbar ist.

3. Speicherbauelement nach Anspruch 1 oder 2,
**dadurch gekennzeichnet ,**
**dass** der Widerstandswert des Widerstandsmaterials (10) durch die Wahl seines spezifischen Widerstands eingestellt ist.

4. Speicherbauelement nach einem der Ansprüche 1 bis 3,
**dadurch gekennzeichnet ,**
**dass** der Widerstandswert des Widerstandsmaterials (10) durch ein geeignetes Layout desselben und/oder des Festkörper-Elektrolytmaterials (13) zwischen den Elektroden (BE, TE) eingestellt ist.

5. Speicherbauelement nach einem der Ansprüche 1 bis 4,
**dadurch gekennzeichnet ,**
**dass** der Widerstandswert des Widerstandsmaterials (10) auf einen Wert eingestellt ist, der zwischen den Widerstandswerten des aktiven Festkörper-Elektroytmaterials (13) im Ein-Zustand und im Aus-Zustand liegt.

6. Verfahren zur Herstellung von Speicherbauelementen (CBRAM) mit Speicherzellen auf der Basis eines in seinem Widerstandswert änderbaren aktiven Festkörper-Elektromaterials (13), das zwischen einer unteren Elektrode (BE) und einer oberen Elektrode (TE) eingebettet wird,
**dadurch gekennzeichnet ,**
**dass** ein Widerstandsmaterial (10) parallel zum Festkörper-Elektrolytmaterial (13) zwischen die untere und obere Elektrode (BE, TE) eingebettet wird.

7. Herstellungsverfahren nach Anspruch 6,
**dadurch gekennzeichnet ,**
**dass** der Widerstandswert des Widerstandsmaterials (10) eingestellt wird.

8. Herstellungsverfahren nach Anspruch 6 oder 7,
**dadurch gekennzeichnet ,**
**dass** der Widerstandswert des Widerstandsmaterials (10) durch die Wahl seines spezifischen Widerstands eingestellt wird.

9. Herstellungsverfahren nach einem der Ansprüche 6 bis 8,
**dadurch gekennzeichnet ,**
**dass** der Widerstandswert des Widerstandsmaterials (10) durch ein geeignetes Layout desselben und/oder des Festkörperelektrolytmaterials (13) zwischen den Elektroden (BE, TE) eingestellt wird.

10. Herstellungsverfahren nach einem der Ansprüche 6 bis 9,
**dadurch gekennzeichnet ,**
**dass** der Widerstandswert des Widerstandsmaterials (10) auf einen Wert eingestellt wird, der zwischen den Widerstandswerten des aktiven Festkörper-Elektrolytmaterials (13) im Ein-Zustand und im Aus-Zustand liegt.

11. Herstellungsverfahren nach einem der Ansprüche 6 bis 10,
**dadurch gekennzeichnet ,**
**dass** zur Strukturierung des Widerstandsmaterials (10) und des Festkörper-Elektrolytmaterials (13) zwischen den Elektroden (BE, TE) eine als Positiv-Maske oder als Negativ-Maske dienende Nanoporen (14) aufweisende Aluminiumoxidschicht (12) verwendet wird.

12. Herstellungsverfahren nach Anspruch 11,
**dadurch gekennzeichnet ,**
**dass** die nanoporöse Aluminiumoxidschicht (12) durch anodische Oxidation einer abgeschiedenen Aluminiumschicht (11) gebildet wird.

13. Herstellungsverfahren nach Anspruch 12,
**dadurch gekennzeichnet ,**
**dass** der Durchmesser der Nanoporen (14) durch die Wahl der Schichtdicke der Aluminiumschicht (11) und der Oxidationsbedingungen eingestellt wird.

14. Herstellungsverfahren nach einem der Ansprüche 6 bis 13,
**dadurch gekennzeichnet ,**
**dass** das Material der unteren Elektrode (BE) W, TiN, TiW oder TiAlN ist.

15. Herstellungsverfahren nach einem der Ansprüche 6 bis 14,
**dadurch gekennzeichnet ,**
**dass** das Widerstandsmaterial (10) polykristallines Silizium oder TiN ist.

16. Herstellungsverfahren nach einem der Ansprüche 6 bis 15,
**dadurch gekennzeichnet ,**
**dass** das Festkörper-Elektrolytmaterial (13) GeSe und Ag oder GeS und Ag ist.

17. Herstellungsverfahren nach einem der Ansprüche 6 bis 16, bei dem die nanoporöse Aluminiumoxidschicht (12) als Positivmaske verwendet wird,
**gekennzeichnet durch** folgende Schritte:
(A1) über einem Substrat (SUB) wird die untere Elektrode (BE) abgeschieden und strukturiert;
(B1) über der unteren Elektrode (BE) wird eine Schicht (10) des Widerstandsmaterials abgeschieden;
(C1) über der Schicht (10) des Widerstandsmaterials wird eine Aluminiumschicht (11) abgeschieden;
(D1) die Aluminiumschicht (11) wird anodisch zu einer Aluminiumoxidschicht (12) oxidiert, wobei sich Nanoporen (14) in dieser Schicht bilden;
(E1) die Widerstandsschicht (10) wird **durch** die Nanoporen (14) selektiv geätzt, wobei sich in dieser Widerstandsschicht (10) ebenfalls Nanoporen bilden;
(F1) eine Schicht (13) des aktiven FestkörperElektrolytmaterials wird über der Aluminiumoxidschicht (12) bis in den Nanoporen der Widerstandsschicht (10) hinein abgeschieden;
(G1) die restliche Aluminiumoxidschicht (12) mit der darüber stehenden Schicht des aktiven Festkörper-Elektrolytmaterials (13) wird entfernt oder der Schichtenstapel **durch** CMP bis zur Widerstandsschicht (10) rückgedünnt;
(H1) über der mit dem aktiven Festkörper-Elektrolytmaterial (13) gefüllten Widerstandsschicht (10) wird die Metallisierung für die zweite Elektrode (TE) abgeschieden.

18. Herstellungsverfahren nach einem der Ansprüche 6 bis 17, bei dem die Aluminiumoxidschicht als Negativmaske verwendet wird,
**gekennzeichnet durch** folgende Schritte:
(A2) über einem Substrat (SUB) wird die untere Elektrode (BE) abgeschieden und strukturiert;
(B2) über der unteren Elektrode (BE) wird eine Schicht (13) des aktiven Festkörper-Elektrolytmaterials abgeschieden;
(C2) über der Schicht (13) des aktiven Festkörper-Elektrolytmaterials wird eine Aluminiumschicht (11) abgeschieden;
(D2) die Aluminiumschicht (11) wird anodisch zu einer Aluminiumoxidschicht (12) oxidiert, wobei sich Nanoporen (14) in dieser Schicht bilden;
(E2) die Schicht (13) des aktiven FestkörperElektrolytmaterials wird selektiv geätzt, wobei sich in dieser Schicht ebenfalls Nanoporen bilden;
(F2) über der Aluminiumoxidschicht (12) und **durch** deren und in die Nanoporen der Schicht (13) des aktiven Festkörper-Elektrolytmaterials hinein wird eine Schicht (10) des Widerstandsmaterials abgeschieden;
(G2) die restliche Aluminiumoxidschicht (12) wird zusammen mit dem darüber liegenden Widerstandsmaterial (10) entfernt, oder die über dem aktiven Festkörper-Elektrolytmaterial (13) liegenden Schichten werden **durch** CMP rückgedünnt;
(H2) über der mit dem Widerstandsmaterial (10) gefüllten Schicht (13) des aktiven Festkörper-Elektrolytmaterials wird die Metallisierung für die obere Elektrode (TE) abgeschieden.

19. Herstellungsverfahren nach einem der Ansprüche 6 bis 16, bei dem die nanoporöse Aluminiumoxidschicht als Negativmaske verwendet wird,
**gekennzeichnet durch** folgende Schritte:
(A3) über einem Substrat (SUB) wird eine untere Elektrode (BE) abgeschieden und strukturiert;
(B3) über der unteren Elektrode (BE) wird eine Aluminiumschicht (11) abgeschieden;
(C3) die Aluminiumschicht (11) wird anodisch zu einer Aluminiumoxidschicht (12) oxidiert, wobei sich in dieser Schicht Nanoporen (14) bilden;
(D3) über der Aluminiumoxidschicht (12) und in deren Nanoporen (14) hinein wird eine Schicht (10) des Widerstandsmaterials abgeschieden;
(E3) die restliche Aluminiumoxidschicht (12) wird zusammen mit dem darüber liegenden Widerstandsmaterial (10) entfernt;
(F3) über der unteren Elektrode (BE) und den darüber stehenden Abschnitten (101 - 103) des Widerstandsmaterials (10) wird eine Schicht (13) des aktiven FestkörperElektrolytmaterials abgeschieden;
(G3) die Schicht des aktiven Festkörper-Elektrolytmaterials (13) wird **durch** CMP bis zur Widerstandsschicht (10) rückgedünnt;
(H3) darüber wird die Metallisierung für die obere Elektrode (TE) abgeschieden.

20. Herstellungsverfahren nach einem der Ansprüche 11 bis 19,
**dadurch gekennzeichnet ,**
**dass** die Nanoporen der Aluminiumoxidschicht einen mittleren Durchmesser im Bereich von 4 bis 10 nm haben.
